# EUROPÄISCHE PATENTSCHRIFT

(11) **EP 1 274 290 B1**
(45) Veröffentlichungstag und Bekanntmachung des Hinweises auf die Patenterteilung: **14.12.2005**
(21) Anmeldenummer: 02011782.6
(22) Anmeldetag: 28.05.2002
(51) Int. Cl.: H05K 7/14

(54) **Gehäuse zur Aufnahme elektrischer Baugruppen**
Housing for electrical subassemblies
Boitier pour ensembles électriques

(30) Priorität: 02.07.2001 DE 10131952
(43) Veröffentlichungstag der Anmeldung: 08.01.2003
(73) Patentinhaber: SIEMENS AKTIENGESELLSCHAFT, 80333 München (DE)
(72) Erfinder: Buchberger, Georg, 80689 Muenchen (DE); Niggl, Heinz-Jürgen, 82343 Pöcking (DE); Steiner, Günther, 81245 München (DE)
(74) Vertreter: Berg, Peter

(56) Entgegenhaltungen:
- EP-A- 0 926 937
- DE-U- 29 714 511
- US-A- 5 642 264
- US-B1- 6 239 984

## Beschreibung

Die Erfindung betrifft ein Gehäuse zur Aufnahme elektrischer Baugruppen mit einer das Gehäuse umfassenden Gehäuseverkleidung, wobei Mittel zum Befestigen der Baugruppen im Gehäuse und Mittel zur Aufnahme wenigstens einer den Baugruppen zugeordneten Rückwandleiterplatte vorgesehen sind.

Eine Anordnung für eine Befestigung einer Rückwandleiterplatte an einem Baugruppenrahmen ist in DE-U-297 14 511 offenbart.

Bei derartigen Gehäusen werden frontseitig elektrische oder elektronische Baugruppen nebeneinander in einen entsprechend ausgebildeten Führungsschacht eingesteckt. Unbefriedigend bei diesem Stand der Technik ist jedoch, daß in einem derartigen Gehäuse lediglich Baugruppen eines einzigen Baugruppenformats unterbringbar sind, so daß für jedes weitere Baugruppenformat jeweils ein entsprechend konfiguriertes Gehäuse erforderlich ist.

Das Dokument US-A-5 642 264 offenbart ein Gehäuse für Baugruppe verschiedener Formate, wo die Rückwandleiterplatte mittels Schrauben an Baugruppensgehäuse befestigt ist.

Es besteht daher die Aufgabe, ein Gehäuse der eingangs genannten Art zu schaffen, das die Unterbringung von Baugruppen verschiedener Baugruppenformate erlaubt, und das eine Befestigung einer Rückwandleiterplatte auf einfache und schnelle Weise ermöglicht.

Gelöst ist diese Aufgabe dadurch, daß Profilschienen mit voneinander beabstandeten Aufnahmeabschnitten vorgesehen sind, daß jeweils einem bestimmten Baugruppenformat wenigstens zwei Führungsabschnitte zugeordnet sind, deren Abstand voneinander an die Größe des Baugruppenformats anpaßbar ist, indem die Führungsabschnitte in nach Maßgabe des jeweiligen Baugruppenformats passende Aufnahmeabschnitte zugeordneter Profilschienen befestigbar sind, und daß die Mittel zur Aufnahme einer Rückwandleiterplatte auf einer Profilschiene angeordnete Befestigungselemente aufweisen.

Charakteristisch für die Erfindung ist mithin, daß ein System aus standardisierten Teilen nach Maßgabe des entsprechenden Baugruppenformats einer Baugruppenanordnung jeweils konfigurierbar ist. Bei Unterbringung von mehreren Baugruppen von unterschiedlichem Baugruppenformat, sind die jeweils ein Baugruppenformat aufnehmenden Führungsabschnitte dadurch konfigurierbar, daß die einem bestimmten Baugruppenformat zugeordneten Führungsabschnitte in die dazu passenden Aufnahmeabschnitte der zugeordneten Profilschienen eingesetzt werden. Da die zum System gehörenden Führungsabschnitte und Profilschienen standardisiert ausgebildet sind, ist das erfindungsgemäße Gehäuse variabel konfigurierbar.

Eine Ausgestaltung der Erfindung sieht vor, daß die Profilschienen wenigstens paarweise an der Stirnseite und an der Rückseite des Gehäuses angeordnet sind. Dadurch lassen sich mittels der zugeordneten Führungsabschnitte Baugruppen sowohl stirnseitig als auch rückseitig in das Gehäuse einstecken.

Eine Weiterbildung der Erfindung besteht darin, daß die Aufnahmeabschnitte in den Profilschienen als Aufnahmeschlitze ausgebildet sind, wobei die Aufnahmeschlitze in Längserstreckungsrichtung der Profilschiene voneinander beabstandet sind und ausgehend von einem Seitenrand der Profilschiene etwa quer zur Längserstreckungsrichtung verlaufen. Dadurch lassen sich die Führungsabschnitte nach Maßgabe der jeweils erforderlichen Baugruppenhöhe in die dazu passenden Aufnahmeschlitze einsetzen. Ferner weisen die Aufnahmeschlitze eine etwa konstante Schlitzbreite und konstante Schlitztiefe auf, wobei die Schlitzbreite der Aufnahmeschlitze etwa an die Dicke der Führungsabschnitte angepaßt ist, wenn die Führungsabschnitte als rechteckförmige Führungsplatten ausgebildet sind.

Typischerweise sind die Profilschienen jeweils an einer Innenwand des Gehäuses angeordnet. Alternativ dazu können die Profilschienen an einer Innenwand des Gehäuses angebogen ausgebildet sein. Zur Trennung von nebeneinander angeordneten Baugruppenanordnungen unterschiedlicher Baugruppenhöhe kann eine Ausgestaltung der Erfindung darin bestehen, daß wenigstens ein Zwischenwandabschnitt vorgesehen ist, an dessen Anlageseiten Profilschienen angeordnet sind. Nach einer weiterbildenden Maßnahme weisen die Profilschienen jeweils einen Z-förmigen Querschnitt auf, wobei die Profilschienen zwei parallel angeordnete und über einen Verbindungsbereich beabstandete Anlageseiten aufweisen, welche sich jeweils von dem senkrecht zu den Anlageseiten angeordneten Verbindungsbereich wegerstrecken. Dabei ist eine Anlageseite zur Anlage an einer Gehäuseinnenwand bestimmt und die parallel davon beabstandete Anlageseite weist die Aufnahmeschlitze auf. Dadurch ist die mit den Aufnahmeschlitzen versehene Anlageseite auch von der zugeordneten Innenwand des Gehäuses beabstandet, so daß sich die Führungsabschnitte relativ einfach in die Aufnahmeabschnitte einpassen lassen.

Eine Ausgestaltung der Erfindung, die der Befestigung einer Rückwandleiterplatte nach Maßgabe der jeweils erforderlichen Baugruppentiefe dient, kann darin bestehen, daß der den Anlageseiten zwischengeordnete Verbindungsbereich als Seitenanschlag für eine Rückwandleiterplatte vorgesehen ist. Die dazu erforderlichen Profilschienen sind je nach Baugruppentiefe in einem mittleren Abschnitt des Gehäuseinnenraums vorgesehen. Dazu weist die einer Gehäuseinnenwand zugeordnete Anlageseite wenigstens ein aus der Anlageseite federnd hochgebogenes Befestigungselement auf, dessen freies Ende dem Verbindungsbereich zugewandt ist und einen Gegenanschlag für eine Rückwandleiterplatte bildet. Dadurch ist die Rückwandleiterplatte in einer Richtung fixiert. Kontaktiert wird die Rückwandleiterplatte, indem die einer Gehäuseinnenwand zugeordnete Anlageseite wenigstens ein aus der Anlageseite federnd hochgebogenes Kontaktelement aufweist, dessen freies Ende dem Verbindungsbereich angrenzend zugewandt ist und dadurch bei bestimmungsgemäßer Anlage der Rückwandleiterplatte deren Seitenkante beaufschlagt. Dabei sind das Befestigungselement und das Kontaktelement jeweils trapezförmig ausgebildet, um eine größere Elastizität der Elemente zu erzielen.

Um die Rückwandleiterplatte auch in einer Querrichtung zu fixieren, ist wenigstens ein Befestigungselement vorgesehen, das sich von der Anlageseite derart wegerstreckt, daß das Befestigungselement in der von der Anlageseite definierten Ebene bleibt und mit seinem freien Ende über den Verbindungsbereich hinaus zur Anlageseite ragt. Dabei ist dem Befestigungselement eine in einer Rückwandleiterplatte vorgesehene Durchbrechung so zugeordnet, daß bei bestimmungsgemäßer Anlage der Rückwandleiterplatte an den Verbindungsbereich das freie Ende durch die Durchbrechung hindurchgreift. Um das Einführen in die zugeordnete Durchbrechung zu erleichtern, ist das Befestigungselement als U-förmige Befestigungslasche ausgebildet.

Eine sichere Fixierung und Kontaktierung der Rückwandleiterplatte ergibt sich, wenn das Befestigungselement, das Kontaktelement und das zweite Befestigungselement in Längserstreckung der Profilschiene voneinander beabstandet sind, wobei die Befestigungselemente und das Kontaktelement etwa quer zur Längserstreckung der Profilschiene verlaufen und die beiden Befestigungselemente sowie das Kontaktelement in Längserstreckung der Profilschiene jeweils gleichmäßig voneinander beabstandet sind.

Zur Be- und Entlüftung des Gehäuseinnenraums weisen die boden- und deckenseitigen Gehäusewände des Gehäuses jeweils eine Vielzahl von Durchbrechungen auf, die gitterförmig wenigstens einen wesentlichen Teil der Fläche der jeweiligen Gehäusewand durchsetzen, so daß sich insgesamt ein großer Strömungsquerschnitt ergibt. Dadurch ist in vertikaler Richtung die im Gehäuseinnenraum erzeugte Verlustwärme durch Konvektion abführbar, während in der Querrichtung eine Zwangsbelüftung mittels Lüftereinrichtungen erforderlich ist. Aus Brandschutzgründen sind die Durchbrechungen als Perforationen ausgebildet, deren Durchmesser eine Größenordnung von 2 mm nicht übersteigt, so daß größere Partikel nicht durch die Perforationen gelangen können. Außerdem ist dadurch das Gehäuse EMV-technisch abgedichtet. Nach einer Weiterbildung der Erfindung kann vorgesehen sein, daß daß an den Eckbereichen des Gehäuses Bohrungen vorgesehen sind. Dadurch sind mehrere erfindungsgemäße Gehäuse mittels Schraubverbindungen miteinander verbindbar, beispielsweise indem die Gehäuseanordnung übereinander stapelbar oder nebeneinander anreihbar ist. Ferner sind an den Bohrungen Füße zur Standaufstellung oder Befestigungselemente zur Wand- und Schrankmontage anbringbar.

Anhand der beigefügten Zeichnungen sollen nachstehend Ausführungsformen der Erfindung näher erläutert werden. In teilweise stark schematischen Ansichten zeigen:
Fig. 1 eine stirnseitige Ansicht eines erfindungsgemäßen Gehäuses mit zwischen zwei horizontal verlaufenden Führungsabschnitten nebeneinander angeordnete Baugruppen aufgenommen sind,
Fig. 2 eine Querschnittdarstellung des Gehäuses von Fig. 1, wobei die stirnseitig eingesteckten Baugruppen mit ihren jeweils der Stirnseite des Gehäuses abgewandten Enden an einer Rückwandleiterplatte fixiert sind, während von einer Rückwand des Gehäuses eine zweite Anordnung von Baugruppen von anderem Format eingesteckt ist, deren zum Gehäuseinnenraum weisenden Enden ebenfalls an der Rückwandleiterplatte fixiert sind,
Fig. 3 eine stirnseitige Ansicht einer anderen Ausführungsform des erfindungsgemäßen Gehäuses, wobei zwei unterschiedliche Höhen-Formate von Baugruppen nebeneinander angeordnet sind und lediglich mittels einer Zwischenstütze voneinander getrennt sind,
Fig. 4 eine Querschnittdarstellung des Gehäuses von Fig. 3, wobei die beiden stirnseitig eingesteckten Anordnungen von Baugruppen unterschiedliche Einstecktiefen aufweisen und jeder Anordnung jeweils eine Rückwandleiterplatte zugeordnet ist,
Fig. 5 eine stirnseitige Ansicht einer weiteren Ausführungsform des erfindungsgemäßen Gehäuses mit drei nebeneinander eingesteckten Anordnungen von Baugruppen, wobei die Anordnungen jeweils unterschiedliche Bauhöhen aufweisen,
Fig. 6 eine Querschnittdarstellung des Gehäuses von Fig. 5, wobei die drei stirnseitig eingesteckten Anordnungen von Baugruppen jeweils unterschiedliche Einstecktiefen aufweisen und jeder Anordnung jeweils eine Rückwandleiterplatte zugeordnet ist,
Fig. 7 eine stirnseitige Ansicht eine weiteren Ausführungsform des erfindungsgemäßen Gehäuses mit zwei stirnseitig eingesteckten Anordnungen von Baugruppen unterschiedlichen Höhen-Formats,
Fig. 8 eine Querschnittdarstellung des Gehäuses von Fig. 7, wobei den beiden stirnseitig aufgenommenen Anordnungen von Baugruppen mit unterschiedlicher Einstecktiefe zwei weitere von der rückwärtigen Seite des Gehäuses eingesteckte Anordnungen von Baugruppen mit jeweils unterschiedlicher Einstecktiefe gegenüberstehen, wobei jedem Paar gegenüberstehender Anordnungen jeweils eine Rückwandleiterplatte zugeordnet ist,
Fig. 9 einen Ausschnitt einer Profilschiene in einer Draufsicht mit an einer Anlageseite entlang der Längserstreckungsrichtung angeordneten Aufnahmeschlitzen sowie Befestigungselemente zur Aufnahme einer Rückwandleiterplatte,
Fig. 10 die Profilschiene in einer Schnittdarstellung gemäß der Schnittlinie X-X von Fig. 9 mit daran befestigter Rückwandleiterplatte,
Fig. 11 die Profilschiene in einer Schnittdarstellung gemäß der Schnittlinie XI-XI von Fig. 9 mit daran kontaktierter Rückwandleiterplatte,
Fig. 12 die Profilschiene in einer Schnittdarstellung gemäß der Schnittlinie XII-XII von Fig. 9 mit daran fixierter Rückwandleiterplatte,
Fig. 13 einen zur Anlage an die Profilschiene von Fig. 9 vorgesehenen Ausschnitt der Rückwandleiterplatte
Fig. 14 eine Querschnittsansicht einer Ausführungsform des erfindungsgemäßen Gehäuses, sowie
Fig. 15 eine teilweise aufgeschnittene perspektivische Darstellung mehrerer nebeneinander und übereinander angeordneter Ausführungsformen des erfindungsgemäßen Gehäuses, wobei sich die Ausführungsformen hinsichtlich der Baubreite und Bauhöhe teilweise voneinander unterscheiden.

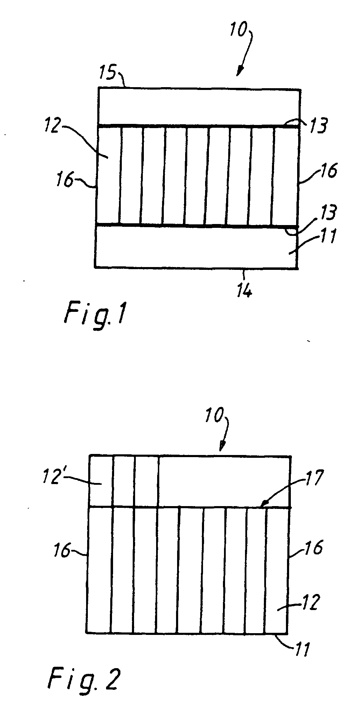

Fig. 1 zeigt ein in seiner Gesamtheit mit 10 bezeichnetes Gehäuse in einer ersten Ausführungsform. An einer Stirnseite 11 des Gehäuses 10 sind nebeneinander angeordnete Baugruppen 12 von jeweils gleichem Höhenmaß eingesteckt. Zur Aufnahme der Baugruppen 12 sind im Gehäuse 10 paarweise einander zugeordnete Führungsabschnitte 13 vorgesehen, welche als etwa rechteckförmige Führungsplatten 13 ausgebildet sind und parallel voneinander beabstandet verlaufen, wobei der Abstand der Führungsplatten 13 entsprechend dem Höhenmaß der eingesteckten Baugruppen 12 einstellbar ist. Ferner sind die Führungsplatten 13 etwa parallel zu einem Gehäuseboden 14 und einer Gehäusedecke 15 angeordnet, wobei sich sowohl die dem Gehäuseboden 14 zugewandte Führungsplatte 13 als auch die der Gehäusedecke 15 zugewandte Führungsplatte 13 zwischen gegenüberstehenden Seitenwänden 16 des Gehäuses 10 erstrecken, an deren innenseitigen Wandungsabschnitten die Führungsplatten 13 befestigt sind.

Fig. 2 zeigt die erste Ausführungsform des Gehäuses 10 in einer Querschnittsansicht. Die stirnseitig eingesteckten Baugruppen 12 weisen auch eine jeweils identische Einstecktiefe auf, so daß ihre von der Stirnseite 11 wegweisenden Enden bündig auf einer im Gehäuseinnenraum senkrecht zu den Führungsplatten 13 angeordnete Rückwandleiterplatte 17 anliegen und dort sowohl fixiert als auch kontaktiert sind. Die Rückwandleiterplatte 17 erstreckt sich zwischen den gegenüberstehenden Seitenwänden 16 und in der dazu quer verlaufenden Richtung zwischen den dem Gehäuseinnenraum zugewandten Kanten der die Baugruppen 12 aufnehmenden Führungsplatten 13. Auf der der Stirnseite 11 entgegengesetzten Rückseite des Gehäuses 10 ist eine zweite Anordnung von Baugruppen 12' eingesteckt, die gegenüber der von der Stirnseite 11 eingesteckten Anordnung dadurch unterscheidet, daß sie ein bezüglich der Einstecktiefe kleineres Baugruppenformat aufweist. In Analogie zur ersten Anordnung der Baugruppen 12 sind der zweiten Anordnung ebenfalls paarweise Führungsplatten zugeordnet. Die jeweils zum Gehäuseinnenraum hinweisenden Enden der zweiten Anordnung von Baugruppen 12' liegen bündig an der ihnen zugewandten Anlageseite der Rückwandleiterplatte 17 an und sind dort sowohl fixiert als auch kontaktiert.

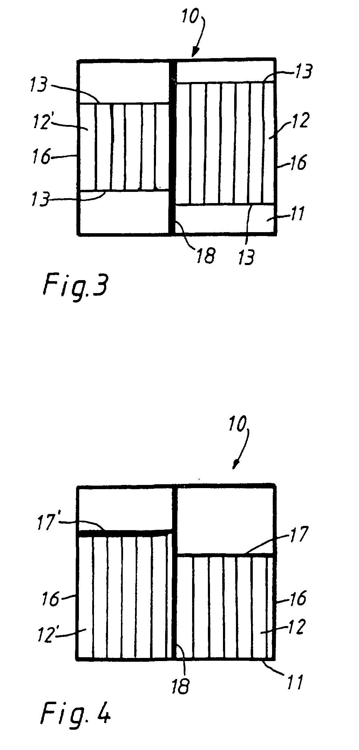

Fig. 3 zeigt eine zweite Ausführungsform des erfindungsgemäßen Gehäuses 10. An der Stirnseite 11 des Gehäuses 10 sind nebeneinander zwei Anordnungen von Baugruppen 12 eingesteckt, die sich bezüglich des Höhenformats voneinander unterscheiden. Die ein größeres Höhenmaß aufweisende Anordnung von Baugruppen 12 ist dabei rechtsseitig von einer den Gehäuseinnenraum vertikal teilenden Zwischenstütze 18 angeordnet, während die mit einem kleineren Höhenmaß versehene Anordnung von Baugruppen 12 linksseitig von der Zwischenstütze 18 angeordnet ist. Jeder der beiden Anordnungen ist jeweils ein Paar parallel beabstandete Führungsplatten 13 zugeordnet. Die der rechtsseitigen Anordnung zugeordneten Führungsplatten 13 erstrecken sich zwischen der rechten Seitenwand 16 des Gehäuses 10 und der dieser Seitenwand 16 zugewandten Anlageseite der Zwischenstütze 18, während sich die der linksseitigen Anordnung zugeordneten Führungsplatten 13 zwischen der linksseitigen Seitenwand 16 und der dieser Seitenwand 16 zugewandten Anlageseite der Zwischenstütze 18 erstrecken. Um den vertikalen Abstand der jeweils ein Paar bildenden Führungsplatten 13 auf das jeweils erforderliche Höhenmaß der jeweils zugeordneten Anordnung von Baugruppen 12 einzustellen, sind jedem Paar von Führungsplatten 13 Schienen mit einer Vielzahl von Aufnahmeabschnitten zugeordnet, wobei die Schienen an innenseitigen Wandungsabschnitten der Seitenwände 16 und an den ihnen jeweils zugewandten Anlageseiten der Zwischenstütze 18 vorgesehen sind, so daß die Führungsplatten 13 nach Maßgabe des jeweils erforderlichen Höhenmaßes der zugeordneten Anordnung von Baugruppen 12 in den entsprechend passenden Aufnahmeabschnitte der zugeordneten Schienen fixiert werden.

Fig. 4 zeigt die zweite Ausführungsform des Gehäuses 10 in einer Querschnittsansicht. Die beiden stirnseitig in das Gehäuse 10 eingesteckten und mittels der Zwischenstütze 18 voneinander getrennten Anordnungen der Baugruppen 12 weisen zusätzlich zu dem jeweils unterschiedlichen Höhenmaß noch eine jeweils unterschiedliche Einstecktiefe auf, so daß jeder Anordnung jeweils eine Rückwandleiterplatte 17, 17' zugeordnet ist. Jede der Rückwandleiterplatten 17, 17' ist im Gehäuseinnenraum so angeordnet, daß die von der Stirnseite 11 wegweisenden Enden der jeweils einer Rückwandleiterplatte 17, 17' zugeordneten Anordnung von Baugruppen 12, 12' jeweils bündig auf der ihnen zugewandten Anlageseite der zugeordneten Rückwandleiterplatte 17, 17' anliegen und dort sowohl fixiert als auch kontaktiert sind. Dabei erstreckt sich die der rechtsseitigen Anordnung von Baugruppen zugeordnete Rückwandleiterplatte zwischen der rechtsseitigen Seitenwand 16 und der ihr zugewandten Anlageseite der Zwischenstütze 18, während sich die linksseitige Anordnung von Baugruppen 12 zwischen der linksseitigen Seitenwand 16 und der ihr zugewandten Anlageseite der Zwischenstütze 18 erstreckt. In der vertikalen Richtung erstreckt sich jede Rückwandleiterplatte 17, 17' zwischen den ihr zugewandten Kanten der zugeordneten Führungsplatten 13.

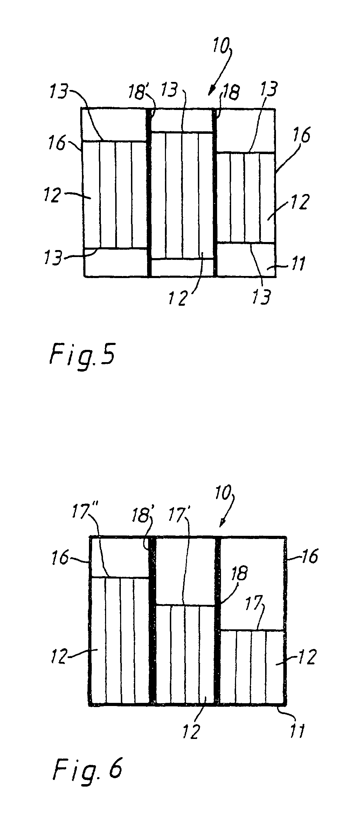

Fig. 5 zeigt eine dritte Ausführungsform des erfindungsgemäßen Gehäuses 10. An der Stirnseite 11 sind drei Anordnungen von Baugruppen 12 unterschiedlicher Bauhöhe eingesteckt, die jeweils durch eine vertikal den Gehäuseinnenraum teilenden Zwischenstütze 18, 18' voneinander getrennt sind, wobei die Zwischenstützen 18, 18' parallel zueinander angeordnet sind. Jeder der drei Anordnungen ist jeweils ein Paar parallel voneinander beabstandeter Führungsplatten 13 zugeordnet. Die der rechtsseitigen Anordnung von Baugruppen zugeordneten Führungsplatte 13 erstrecken sich zwischen der rechten Seitenwand 16 und der dazu unmittelbar benachbarten Zwischenstütze 18, während sich die der linksseitigen Anordnung von Baugruppen 12 zugeordneten Führungsplatten 13 zwischen der linken Seitenwand 16 und der dazu unmittelbar benachbarten Zwischenstütze 18' erstrecken, so daß sich die der mittleren Anordnung von Baugruppen 12 zugeordneten Führungsplatten 13 zwischen den beiden benachbarten Zwischenstützen 18, 18' erstrecken. Die zur Anpassung des Abstands der jeweiligen Führungsplatten 13 an das jeweilige Höhenmaß der einzelnen Anordnungen vorgesehenen Schienen sind für die rechtsseitige Anordnung an dem innenseitigen Wandungsabschnitt der rechten Seitenwand 16 und der ihr zugewandten Anlageseite der benachbarten Zwischenstütze 18 vorgesehen; für die linksseitige Anordnung sind die entsprechenden Schienen an dem innenseitigen Wandungsabschnitt der linken Seitenwand 16 und der ihr zugewandten Anlageseite der benachbarten Zwischenstütze 18' vorgesehen, so daß die Schienen für die mittlere Anordnung an ihr jeweils zugewandten Anlageseiten der beiden Zwischenstützen 18, 18' vorgesehen sind.

Fig. 6 zeigt die dritte Ausführungsform des Gehäuses in einer Querschnittsansicht. Die drei stirnseitig in das Gehäuse 10 eingesteckten und mittels der beiden Zwischenstützen 18, 18' voneinander getrennten Anordnungen der Baugruppen 12 weisen jeweils unterschiedliche Einstecktiefen auf, so daß jeder der drei Anordnungen jeweils eine Rückwandleiterplatte 17, 17', 17'' zugeordnet ist. Die Rückwandleiterplatten sind so angeordnet, daß die von der Stirnseite 11 wegweisenden Enden der jeweiligen Anordnung von Baugruppen 12 bündig auf der ihnen zugewandten Anlageseite der zugeordneten Rückwandleiterplatte 17, 17', 17'' anliegen und dort sowohl fixiert als auch kontaktiert sind.

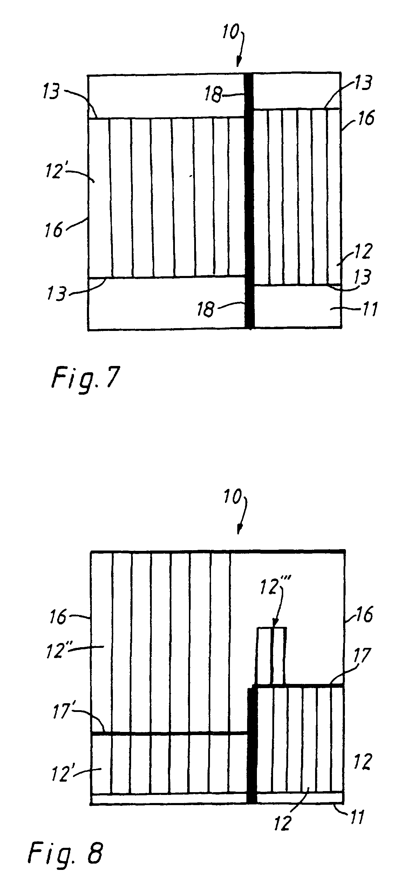

Fig. 7 zeigt eine vierte Ausführungsform des erfindungsgemäßen Gehäuses 10. An der Stirnseite 11 des Gehäuses 10 ist rechtsseitig von einer den Gehäuseinnenraum vertikal teilenden Zwischenstütze 18 eine Anordnung von Baugruppen 12 eingesteckt, während linksseitig von der Zwischenstütze 18 eine sog. "Patchpanel" - Steckfeldanordnung 12' aufgenommen ist, wobei sich die Anordnung der Baugruppen 12 und die Steckfeldanordnung 12' bezüglich des Höhenformats voneinander unterscheiden. Die der Anordnung von Baugruppen 12 und der Steckfeldanordnung 12' jeweils zugeordneten Führungsplatten 13 sind entsprechend dem jeweils erforderlichen Höhenmaß in dazu passende Aufnahmeabschnitte zugeordneter Schienen so eingesetzt, daß der Abstand der jeweils ein Paar bildenden Führungsplatte 13 mit dem Höhenmaß der jeweils zugeordneten Anordnung übereinstimmt. Die Schienen sind dabei an den innenseitigen Wandabschnitten der Seitenwände 16 und an den ihnen jeweils zugewandten Anlageseiten der Zwischenstütze 18 angeordnet, so daß sich die der jeweiligen Anordnung zugeordneten Führungsplatten 13 zwischen der jeweiligen Anlageseite der Zwischenstütze 18 und dem ihr jeweils zugewandten innenseitigen Wandabschnitt der Seitenwand 16 erstrecken.

Fig. 8 zeigt die vierte Ausführungsform des Gehäuses 10 in einer Querschnittsansicht. Die Anordnung der Baugruppe 12 und die Steckfeldanordnung 12' weisen unterschiedliche Einstecktiefen auf, so daß für jede der beiden Anordnungen jeweils eine Rückwandleiterplatte 17, 17' vorgesehen ist. Da die Anordnung der Baugruppen 12 eine größere Einstecktiefe als die nebengeordnete Steckfeldanordnung 12' aufweist, ist die zugeordnete Rückwandleiterplatte 17 tiefer im Gehäuseinnenraum angeordnet, wobei sich die Zwischenstütze 18 von der Stirnseite 11 bis zu hinteren Rückwandleiterplatte 17 erstreckt. Die zum Gehäuseinnenraum hinweisenden Enden der jeweiligen Anordnung 12, 12' liegen bündig an der ihnen zugewandten Anlageseite der jeweils zugeordneten Rückwandleiterplatte 17, 17' an und sind dort sowohl fixiert als auch kontaktiert. Auf der der Stirnseite 11 entgegengesetzen Rückseite des Gehäuses 10 sind zwei weitere Anordnungen von Baugruppen 12'', 12''' eingesteckt, wobei sich die beiden Anordnungen bezüglich der Einstecktiefe unterscheiden. Diesen beiden Anordnungen ist ebenfalls jeweils ein Paar von Führungsplatten 13 zugeordnet. Die jeweils zum Gehäuseinnenraum hinweisenden Enden dieser beiden Anordnungen liegen bündig an der Anlageseite der ihnen jeweils zugeordneten Rückwandleiterplatte 13 an.

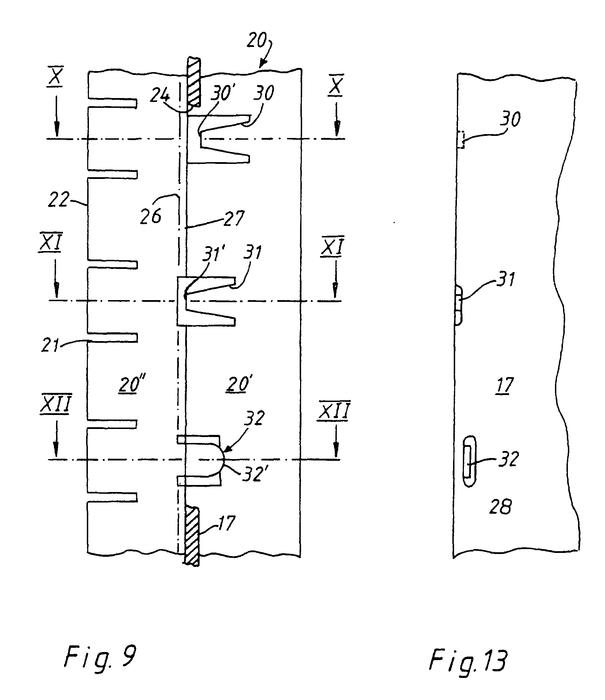

Fig. 9 veranschaulicht eine zum Positionieren der Führungsplatten 13 vorgesehene Profilschiene 20, die sowohl zur Aufnahme der Führungsplatten 13 als auch zur Aufnahme einer Rückwandleiterplatte 17 dient und demgemäß im rückwärtigen Gehäuseinnenraum angeordnet ist. Die Profilschienen 20 sind an einander zugewandten Anlageseiten der Seitenwände 16 und/oder der Zwischenstütze 18 des Gehäuses 10 vorgesehen. Die in Fig. 9 dargestellte Profilschiene 20 weist in Richtung ihrer Längserstreckung voneinander beabstandete Aufnahmeschlitze 21 auf, wobei der jeweilige Abstand ungefähr einem Rastermaß von vorzugsweise 25 mm entspricht. Dabei verlaufen die Aufnahmeschlitze 21 ausgehend von einem Seitenrand 22 der Profilschiene 20 jeweils quer zur Längserstreckung der Profilschiene 20 und zwar mit jeweils konstanter Schlitzlänge. Zur Aufnahme einer Rückwandleiterplatte 17, welche bei bestimmungsgemäßer Montage mit ihrer Seitenkante 24 auf einer Anlagefläche der Profilschiene 20 anliegt, weist die Profilschiene 20 verschiedene Elemente 30, 31, 32 auf; da die Seitenkante 24 der Rückwandleiterplatte 17 entlang der Längserstreckungsrichtung der Profilschiene 20 anliegt und zwar entlang eines durch eine in Längserstreckungsrichtung der Profilschiene verlaufenden Falzkante 26 gebildeten hochgekanteten Bereichs 27, sind diese Elemente 30, 31, 32 beabstandet voneinander etwa entlang der Längserstreckungsrichtung der Profilschiene 20 angeordnet. Ein erstes Element 30 ist als ungefähr trapezförmiger Halteflansch 30 ausgebildet, welcher derart in der Profilschiene 20 gestanzt ist, daß die verjüngte Trapezgrundlinie 30' als freies Ende des Halteflansches 30 der Falzkante 26 der Profilschiene 20 zugewandt ist und dabei einen Abstand zum hochgekanten Bereich 27 aufweist, der etwa der Dicke der Seitenkante 24 der Rückwandleiterplatte 17 entspricht. Da der durch die Stanzeinschnitte gebildete Halteflansch 30 zungenförmig aus der Profilschiene 20 herausgebogen ist, steht das freie Ende 30' der Zunge 30 federnd auf der zugewandten quer zur Seitenkante 24 verlaufenden Anlageseite der Rückwandleiterplatte 17 auf. Ein zweites Element 31, welches etwa mit doppeltem Rastermaß von dem ersten Element 30 beabstandet ist, ist wie das erste Element 30 ebenfalls als trapez- bzw. zungenförmiger Halteflansch 31 ausgebildet und weist im wesentlichen die gleichen Dimensionen auf. Die Lage des Halteflansches 31 ist jedoch so festgelegt, daß das freie Ende 31' sich zur Falzkante 26 soweit hinerstreckt, daß das freie Ende 31' die Seitenkante 24 der Rückwandleiterplatte 17 federnd beaufschlagt; es dient der Kontaktierung zwischen der Rückwandleiterplatte 17 und Profilschiene 20. Ein drittes Element 32, welches von dem zweiten Element 31 mit etwa doppeltem Rastermaß und demgemäß von dem ersten Element 30 mit etwa vierfachem Rastermaß beabstandet ist, ist als U-förmige Befestigungslasche 32 mittels eines Stanzeinschnittes ausgebildet; die dadurch gebildete Zunge 32 erstreckt sich gegensinnig zur Verlaufsrichtung der beiden anderen Elemente 30, 31 und steht mit ihrem freien Ende 32' über die Falzkante 26 hinaus.

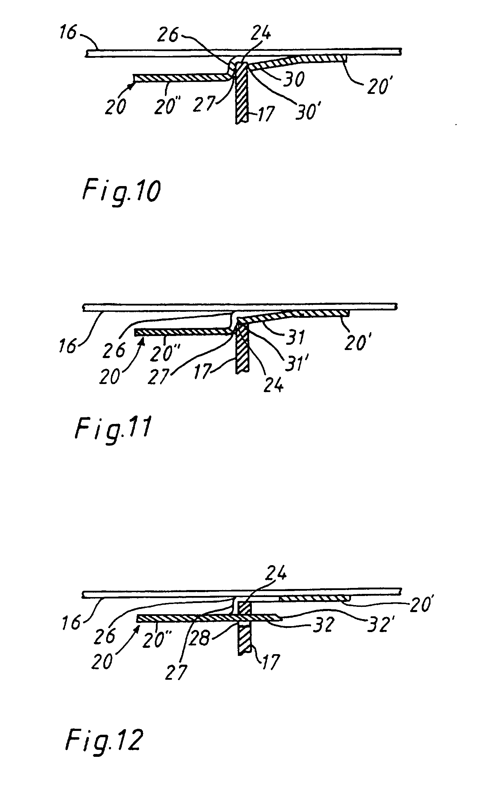

Wie aus Fig. 10 ersichtlich ist, weist die Profilschiene 20 einen ungefähr Z-förmig gebogenen Querschnitt auf, wobei eine Anlageseite 20' der Profilschiene 20 zur Anlage an einer Gehäusewand 16 vorgesehen ist und sich bis zu der Falzkante 26 erstreckt, die entlang der Längserstreckungsrichtung der Profilschiene 20 verläuft; an der Falzkante 26 ist die Profilschiene 20 senkrecht hochgekantet, wobei die der Anlageseite 20' gegenüberliegende und mit Aufnahmeschlitzen 21 versehene Seite 20'' von dort so abgekantet ist, daß diese Seite 20'' etwa parallel zur gegenüberliegenden Anlageseite 20' verläuft und somit auch parallel von der zugeordneten Gehäusewand 16 beabstandet ist. Dabei dient der hochgekantete Bereich 27 als Seitenanschlag für die Rückwandleiterplatte 17, während der aus der Anlageseite 20' rampenförmig und federnd hochstehende und mit seinem freien Ende 30' dem hochgekanteten Bereich 27 zugewandte Halteflansch 30 die Rückwandleiterplatte 17 gegen den hochgekanteten Bereich 27 preßt und dadurch einen Gegenanschlag für die Rückwandleiterplatte 17 bildet.

Wie aus Fig. 11 ersichtlich ist, steht der Halteflansch 31 ebenfalls winklig und federnd aus der Anlageseite 20' hoch, wobei das freie zungenförmige Ende 31' dem hochgekanteten Bereich 27 zugewandt ist und dort angrenzt, so daß die seitlich an dem hochgekanteten Bereich 27 anliegende Rückwandleiterplatte 17 mit ihrer der zugeordneten Gehäusewand 16 zugewandten Seitenkante auf dem freien Ende 31' des Halteflansches 31 aufsteht. Da die Rückwandleiterplatte 17 eine elektrisch leitende Schirmfläche aufweist und die Profilschiene 20 als metallisch leitendes Blechbiegeteil ausgebildet ist, ist die Rückwandleiterplatte 17 mittels des federnd vorstehenden Halteflansches 31 mit der Profilschiene 20 und somit mit der zugeordneten Gehäusewand 16 kontaktiert.

Wie aus Fig. 12 ersichtlich ist, erstreckt sich die Befestigungslasche 32 geradlinig von der mit Aufnahmeschlitzen 21 versehenen Seite 20'' über den hochgekanteten Bereich 27 zur Anlageseite 20' hin, wobei das freie Ende 32' der Befestigungslasche 32 parallel beabstandet von der Anlageseite 20'' verläuft. Dadurch durchgreift die Befestigungslasche 32 eine zugeordnete Durchbrechung 28 in der Rückwandleiterplatte 17 und arretiert somit die Rückwandleiterplatte 17 in einer quer zur Erstreckungsrichtung des Halteflansches 32 verlaufenden Richtung.

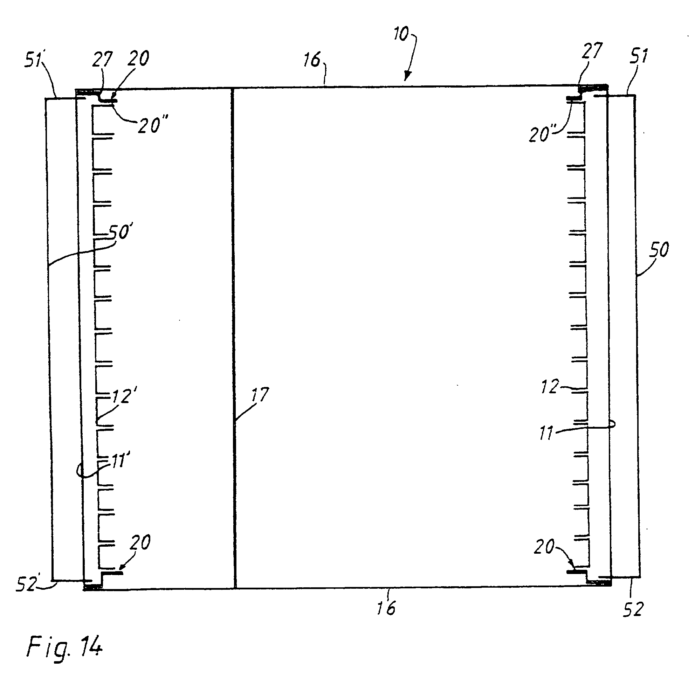

Fig. 13 zeigt die zugeordnete Rückwandleiterplatte 17 in einem Fig. 9 entsprechenden Ausschnitt. Die Rückwandleiterplatte 17 weist eine in der Nähe der Seitenkante 24 angeordnete Durchbrechung 28 auf, welche bei bestimmungsgemäßer Einbaulage der Rückwandleiterplatte 17 die Befestigungslasche 32 hindurchgreift. Da sich die Befestigungslasche 32 gegensinnig zu den Halteflanschen 30,31 erstreckt, läßt sich die Rückwandleiterplatte 17 einfach montieren, indem die Rückwandleiterplatte 17 von der Anlageseite 20' her in Richtung der Falzkante 26 geschoben wird, wobei die Befestigungslasche 32 die Durchbrechung 28 durchgreift und beim Anschlag der Rückwandleiterplatte 17 an dem hochgekanteten Bereich 27 der Halteflansch 30 an der dem hochgekanteten Bereich 27 abgewandten Seite der Rückwandleiterplatte 17 federnd hochschnappt und dadurch die Rückwandleiterplatte 17 seitlich arretiert, während die Befestigungslasche 32 für eine Arretierung in der quer dazu verlaufenden Richtung sorgt. Die Sequenz der drei Elemente 30 bis 32 kann sich bei entsprechender Längserstreckung der Profilschiene 20 fortpflanzen.

Die in den Fig. 9 bis 13 dargestellte Profilschiene 20 mit den darin aufgenommenen Aufnahmeschlitzen 21 sowie den Elementen 30, 31, 32 ist in dieser Kombination zur Befestigung einer Rückwandleiterplatte 17 und von in den Fig. 9-13 nicht dargestellten Führungsebenen vorgesehen; diese Profilschienen ermöglichen somit die Aufnahme unterschiedlicher Baugruppentiefen und sind demgemäß nach Maßgabe der jeweils erforderlichen Baugruppentiefe im mittleren Bereich des Gehäuseinnenraums vorgesehen.

Demgegenüber weisen die in Fig. 1-8 beschriebenen Profilschienen zwar ebenfalls einen Z-förmigen Querschnitt auf, weichen jedoch dadurch von der in den Fig. 9-13 dargestellten Ausführungsform ab, daß die Elemente 30-32 fehlen, da die in Fig. 1-8 erläuterte Ausführungsform zur Aufnahme bzw. Positionierung der paarweise zugeordneten Führungsplatten 13 lediglich die Aufnahmeschlitze 21 benötigt, welche auf der Seite 20'' angeordnet sind, während die Anlageseite 20' an einer Innenwand des Gehäuses 10 oder der Zwischenstütze 18 befestigt oder angeformt ist. Demgemäß sind diese Schienen jeweils paarweise an der Stirnseite und an der Rückseite des Gehäuses 10 angeordnet, wobei sie in ihrer Längserstreckungsrichtung zweckmäßigerweise vertikal ausgerichtet sind, während senkrecht dazu die gemäß Fig. 9-13 für die Rückwandleiterplatte 17 vorgesehenen Profilschienen nach Maßgabe der jeweils erforderlichen Baugruppentiefe im mittleren Bereich angeordnet sind.

Fig. 14 zeigt in einer stark schematisch gehaltenen Querschnittdarstellung das erfindungsgemäße Gehäuse 10, bei dem die im Querschnitt Z-förmigen Profilschienen 20 paarweise jeweils im vorderen und hinteren Gehäuseinnenraum angeordnet sind und zwar an den gegenüberliegenden Seitenwänden 16; dabei sind an den innenwandseitigen an die Stirnseite 11 angrenzenden Kantenbereichen der Seitenwände 16 die Profilschienen 20 so angeordnet, daß die Anlageseiten 20' der Profilschienen der Stirnseite 11 zugewandt und die die Aufnahmeschlitze aufweisenden Seiten 20'' von der Stirnseite abgewandt sind. Analog dazu sind an den an die Rückseite 11' angrenzenden Kantenbereichen der Seitenwände 16 die Profilschienen 20 so angeordnet, daß die Anlageseiten 20' der Rückseite 11' zugewandt und die Seiten 20'' von der Rückseite 11' abgewandt sind. Im Gehäuse 10 sind zwei Baugruppenanordnungen aufgenommen, von denen in Fig. 14 lediglich die jeweils zugeordneten Blendenabschnitte 12, 12' dargestellt sind. Im Innenraum des Gehäuses 10 ist parallel zur Stirnseite 11 und zur Rückseite 11' eine Rückwandleiterplatte 17 angeordnet, an deren der Stirnseite 11 zugewandten Anlageseite die ihr zugeordneten Enden der von der Stirnseite 11 eingesteckten Baugruppenanordnung 12 kontaktiert sind, während an der der Rückseite 11' zugewandten Anlageseite der Rückwandleiterplatte 17 die ihr zugeordneten Enden der von der Rückseite 11' des Gehäuses 10 eingesteckten Baugruppenanordnung 12' kontaktiert sind, wobei beide Baugruppenanordnungen 12, 12' unterschiedliche Baugruppentiefen aufweisen. Um das Gehäuse 10 an seiner Stirnseite 11 und an seiner Rückseite 11' elektromagnetisch abzuschirmen, kann nach einer Ausführungsalternative der der stirnseitigen Baugruppenanordnung zugeordnete metallische Blendenabschnitt 12, der sich aus im Querschnitt U-förmigen Einzelblenden der Baugruppen zusammensetzt, an entsprechenden Führungsplatten befestigt sein, während der der rückseitigen Baugruppenanordnung zugeordnete metallische Blendenabschnitt 12', der sich ebenfalls aus U-förmigen Einzelblenden zusammensetzt, an entsprechenden Führungsplatten befestigt sein kann. Da die Einzelblenden mit den jeweils unmittelbar benachbarten Blenden in Kontakt stehen, bildet der jeweilige Blendenabschnitt 12, 12' insgesamt eine Schirmebene. Alternativ dazu ist an der Stirnseite 11 und an der Rückseite 11' jeweils eine geschirmte Abdeckung 50, 50' vorgesehen. Jede Abdeckung 50, 50' weist einen etwa U-förmigen Querschnitt auf und erstreckt sich über die jeweils zugeordnete Stirnseite 11 bzw. Rückseite 11', wobei die stirnseitige Abdeckung 50 mit ihren Abkantungen 51, 52 an Anlageseiten 20' der stirnseitig zugeordneten Profilschienen 20 kontaktiert ist und die rückseitige Abdeckung 50' mit ihren Abkantungen 51', 52' an Anlageseiten 20' der rückseitig zugeordneten Profilschienen 20 kontaktiert ist. Dadurch ist das Gehäuse 10 nach außen EMV-technisch abgeschirmt; da die Anlageseiten der Rückwandleiterplatte 17 jeweils geschirmt ausgebildet sind, sind beide Baugruppenanordnungen EMV-technisch voneinander abgeschirmt.

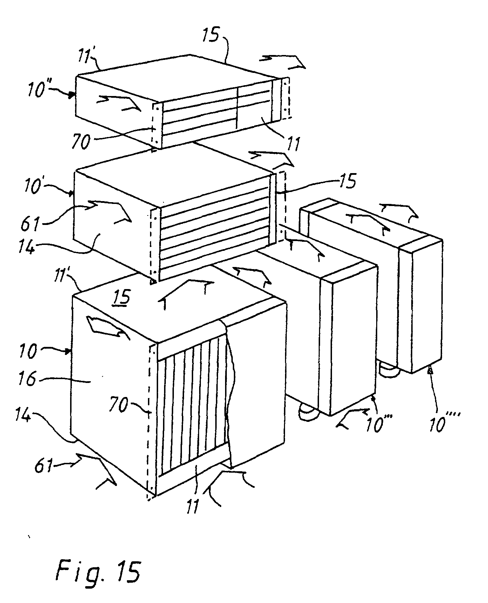

Fig. 15 zeigt verschiedene Ausführungsbeispiele des erfindungsgemäßen Gehäuses 10, 10', 10'', 10''', 10'''', wobei die übereinander angeordneten Gehäuse 10, 10', 10'' gleiche Baubreiten und gleiche Bautiefen aufweisen, während die nebeneinander angeordneten Gehäuse 10, 10''', 10'''' gleiche Bauhöhen und gleiche Bautiefen aufweisen, so daß die Gehäuse 10, 10', 10'' übereinander stapelbar und die Gehäuse 10, 10''', 10'''' nebeneinander anreihbar sind. Durch - in Fig. 15 nicht dargestellte - Bohrungen an den Eckbereichen der Gehäuse sind die nebeneinander oder übereinander angeordneten Gehäuse miteinander mittels Schrauben verbindbar. Ferner sind Befestigungswinkel 70 an den Bohrungen anbringbar, die dann paarweise an der Stirnseite 11 oder der Rückseite 11' angeordnet sind, so daß derart konfigurierte Gehäuse beispielsweise in ein 19-Zoll-Rack einbaubar sind. Dabei läßt sich in Abhängigkeit von einer stirn- oder rückseitigen Anordnung der Befestigungswinkel 70 das Gehäuse mit seiner Stirnseite oder 180° gedreht dazu mit seiner Rückseite als Bedienseite einbauen. Desweiteren lassen sich an den Bohrungen Füße zur Standaufstellung oder Befestigungselemente zur Wandmontage anbringen.

Zur Belüftung weist jedes Gehäuse 10, 10', 10'', 10''', 10'''' in den Gehäusewänden 14, 15 eine Perforation auf. Dadurch ergibt sich - wie die in Fig. 15 dargestellten Strömungsrichtungen 61 zeigen - insgesamt ein relativ großer Lüftungsquerschnitt, so daß sich eine räumlich gleichmäßige Be- und Entlüftung des Gehäuseinnenraums erzielen läßt, indem in vertikaler Richtung die im Gehäuseinnenraum erzeugte Verlustwärme durch Konvektion abführbar ist, während in den quer dazu verlaufenden Richtungen eine Zwangsbelüftung mittels Lüftereinrichtungen vorgesehen ist. Aus Brandschutzgründen ist der Durchmesser der jeweiligen Perforationen im Größenordnungsbereich von 2mm, um im Brandfall ein Austreten von Partikeln, die größer als 2 mm sind, aus einem derartigen Gehäuse zu verhindern.

## Patentansprüche

1. Gehäuse zur Aufnahme elektrischer Baugruppen mit einer das Gehäuse umfassenden Gehäuseverkleidung, wobei Mittel zum Befestigen der Baugruppen im Gehäuse und Mittel zur Aufnahme wenigstens einer den Baugruppen zugeordneten Rückwandleiterplatte vorgesehen sind,
**dadurch gekennzeichnet,**
**daß** Profilschienen (20) mit voneinander beabstandeten Aufnahmeabschnitten (21) vorgesehen sind, daß jeweils einem bestimmten Baugruppenformat wenigstens zwei Führungsabschnitte (13) zugeordnet sind, deren Abstand voneinander an die Größe des Baugruppenformats anpaßbar ist, indem die Führungsabschnitte (13) in nach Maßgabe des jeweiligen Baugruppenformats passende Aufnahmeabschnitte (21) zugeordneter Profilschienen (20) befestigbar sind, und daß die Mittel zur Aufnahme einer Rückwandleiterplatte (17) auf einer Profilschiene (20) angeordnete Befestigungselemente (30, 31, 32) aufweisen.

2. Gehäuse nach Anspruch 1, **dadurch gekennzeichnet, daß** die Profilschienen (20) wenigstens paarweise an der Stirnseite (11) und an der Rückseite des Gehäuses (10) angeordnet sind.

3. Gehäuse nach Anspruch 2, **dadurch gekennzeichnet, daß** die Aufnahmeabschnitte (21) in den Profilschienen (20) als Aufnahmeschlitze ausgebildet sind.

4. Gehäuse nach Anspruch 3, **dadurch gekennzeichnet, daß** die Aufnahmeschlitze (21) in Längserstreckungsrichtung der Profilschiene (20) voneinander beabstandet sind.

5. Gehäuse nach Anspruch 4, **dadurch gekennzeichnet, daß** die Aufnahmeschlitze (21) ausgehend von einem Seitenrand (22) der Profilschiene (20) etwa quer zur Längserstreckungsrichtung verlaufen.

6. Gehäuse nach Anspruch 4 oder 5, **dadurch gekennzeichnet, daß** die Aufnahmeschlitze (21) eine etwa konstante Schlitzbreite und konstante Schlitztiefe aufweisen.

7. Gehäuse nach Anspruch 6, **dadurch gekennzeichnet, daß** die Schlitzbreite der Aufnahmeschlitze (21) etwa an die Dicke der Führungsabschnitte (13) angepaßt ist.

8. Gehäuse nach Anspruch 7, **dadurch gekennzeichnet, daß** die Führungsabschnitte (13) als rechteckförmige Führungsplatten ausgebildet sind.

9. Gehäuse nach einem der Ansprüche 1 bis 8, **dadurch gekennzeichnet, daß** die Profilschienen (20) jeweils an wenigstens einer Innenwand des Gehäuses (20) angeordnet sind.

10. Gehäuse nach Anspruch 9, **dadurch gekennzeichnet, daß** die Profilschienen (20) an wenigstens einer Innenwand des Gehäuses (10) angebogen ausgebildet sind.

11. Gehäuse nach Anspruch 9 oder 10, **dadurch gekennzeichnet, daß** wenigstens ein Zwischenwandabschnitt (18) vorgesehen ist, an dessen Anlageseiten Profilschienen (20) angeordnet sind.

12. Gehäuse nach einem der Ansprüche 1 bis 11, **dadurch gekennzeichnet, daß** die Profilschienen (20) jeweils einen Z-förmigen Querschnitt aufweisen.

13. Gehäuse nach Anspruch 12, **dadurch gekennzeichnet, daß** die Profilschienen (20) zwei parallel angeordnete und über einen Verbindungsbereich (27) beabstandete Anlageseiten (20', 20'') aufweisen, welche sich jeweils von dem senkrecht zu den Anlageseiten (20', 20'') angeordneten Verbindungsbereich (27) wegerstrecken.

14. Gehäuse nach Anspruch 13, **dadurch gekennzeichnet, daß** eine Anlageseite (20') zur Anlage an einer Gehäuseinnenwand bestimmt ist und die parallel davon beabstandete Anlageseite (20'') die Aufnahmeschlitze (21) aufweist.

15. Gehäuse nach Anspruch 14, **dadurch gekennzeichnet, daß** der den Anlageseiten (20', 20'') zwischengeordnete Verbindungsbereich (27) als Seitenanschlag für eine Rückwandleiterplatte (17) vorgesehen ist.

16. Gehäuse nach Anspruch 15, **dadurch gekennzeichnet, daß** die einer Gehäuseinnenwand zugeordnete Anlageseite (20') wenigstens ein aus der Anlageseite (20') federnd hochgebogenes Befestigungselement (30) aufweist, dessen freies Ende (30') dem Verbindungsbereich (27) zugewandt ist und einen Gegenanschlag für eine Rückwandleiterplatte (17) bildet.

17. Gehäuse nach Anspruch 15 oder 16, **dadurch gekennzeichnet, daß** die einer Gehäuseinnenwand zugeordnete Anlageseite (20') wenigstens ein aus der Anlageseite (20') federnd hochgebogenes Kontaktelement (31) aufweist, dessen freies Ende (31') dem Verbindungsbereich (27) zugewandt ist.

18. Gehäuse nach Anspruch 16 oder 17, **dadurch gekennzeichnet, daß** das Befestigungselement (30) und das Kontaktelement (31) jeweils trapezförmig ausgebildet sind.

19. Gehäuse nach einem der Ansprüche 15 bis 18, **dadurch gekennzeichnet, daß** wenigstens ein Befestigungselement (32) vorgesehen ist, das sich von der Anlageseite (20'') derart wegerstreckt, daß das Befestigungselement (32) in der von der Anlageseite (20'') definierten Ebene bleibt und mit seinem freien Ende (32') über den Verbindungsbereich (27) hinaus zur Anlageseite (20') ragt.

20. Gehäuse nach Anspruch 19, **dadurch gekennzeichnet, daß** dem Befestigungselement (32) eine in einer Rückwandleiterplatte (17) vorgesehene Durchbrechung (28) so zugeordnet ist, daß bei bestimmungsgemäßer Anlage der Rückwandleiterplatte (17) an den Verbindungsbereich (27) das freie Ende (32') durch die Durchbrechung (28) hindurchgreift.

21. Gehäuse nach Anspruch 19 oder 20, **dadurch gekennzeichnet, daß** das Befestigungselement (32) als U-förmige Befestigungslasche ausgebildet ist.

22. Gehäuse nach einem der Ansprüche 15 bis 21, **dadurch gekennzeichnet, daß** das Befestigungselement (30), das Kontaktelement (31) und das Befestigungselement (32) in Längserstreckung der Profilschiene (20) voneinander beabstandet sind.

23. Gehäuse nach Anspruch 22, **dadurch gekennzeichnet, daß** die Befestigungselemente (30, 32) und das Kontaktelement (31) etwa quer zur Längserstreckung der Profilschiene (20) verlaufen.

24. Gehäuse nach Anspruch 22 oder 23, **dadurch gekennzeichnet, daß** das Befestigungselement (30), das Kontaktelement (31) und das Befestigungselement (32) in Längserstreckung der Profilschiene (20) jeweils gleichmäßig voneinander beabstandet sind.

25. Gehäuse nach einem der Ansprüche 1 bis 24, **dadurch gekennzeichnet, daß** gegenüberliegende Gehäusewände (14, 15) des Gehäuses (10) jeweils eine Vielzahl von Durchbrechungen aufweisen, die gitterförmig wenigstens einen wesentlichen Teil der Fläche der jeweiligen Gehäusewand (14, 15) durchsetzen.

26. Gehäuse nach Anspruch 25, **dadurch gekennzeichnet, daß** die Durchbrechungen als Perforationen ausgebildet sind, deren Durchmesser eine Größenordnung von 2 mm nicht übersteigt.

27. Gehäuse nach einem der Ansprüche 1 bis 25, **dadurch gekennzeichnet, daß** an den Eckbereichen des Gehäuses (10) Bohrungen vorgesehen sind.

## Claims

1. Enclosure for housing electrical subassemblies having enclosure panelling encompassing the enclosure, wherein means for fixing the subassemblies in the enclosure and means for housing at least one backplane printed circuit board assigned to the subassemblies are provided,
**characterised in that**
profile rails (20) with receiving sections (21) spaced apart from one another are provided, that at least two guide sections (13) are assigned in each case to a specific subassembly format, the distance of said guide sections (13) from one another being adjustable to the size of the subassembly format **in that** the guide sections (13) can be secured in matching receiving sections (21) of assigned profile rails (20), said receiving sections (21) corresponding to the respective subassembly format, and that the means for receiving a backplane printed circuit board (17) have fixing elements (30, 31, 32) disposed on a profile rail (20).

2. Enclosure according to claim 1, **characterised in that** the profile rails (20) are disposed at least in pairs at the front (11) and at the rear of the enclosure (10).

3. Enclosure according to claim 2, **characterised in that** the receiving sections (21) in the profile rails (20) are embodied as receiving slots.

4. Enclosure according to claim 3, **characterised in that** the receiving slots (21) in the direction of longitudinal extension of the profile rail (20) are spaced apart from one another.

5. Enclosure according to claim 4, charactcrised in that the receiving slots (21), starting from a side edge (22) of the profile rail (20), run approximately transversely to the direction of longitudinal extension.

6. Enclosure according to claim 4 or 5,
**characterised in that** the receiving slots (21) have an approximately constant slot width and constant slot depth.

7. Enclosure according to claim 6, **characterised in that** the slot width of the receiving slots (21) is approximately matched to the thickness of the guide sections (13).

8. Enclosure according to claim 7, **characterised in that** the guide sections (13) arc embodied as rectangular guide plates.

9. Enclosure according to one of the claims 1 to 8,
**characterised in that** the profile rails (20) are disposed in each case on at least one inner wall of the enclosure (20).

10. Enclosure according to claim 9, **characterised in that** the profile rails (20) are embodied in a bent shape on at least one inner wall of the enclosure (10).

11. Enclosure according to claim 9 or 10,
**characterised in that** at least one intermediate wall section (18) is provided, at the bearing sides of which
profile rails (20) are disposed.

12. Enclosure according to one of the claims 1 to 11,
**characterised in that** the profile rails (20) each have a Z-shaped cross-section.

13. Enclosure according to claim 12, **characterised in that** the profile rails (20) have two bearing sides (20', 20") arranged in parallel and spaced apart via a connecting area (27), each of which bearing sides (20', 20") extends away from the connecting area (27) arranged perpendicularly to the bearing sides (20', 20").

14. Enclosure according to claim 13, **characterised in that** one bearing side (20' ) is intended to bear on an inner wall of the enclosure and the bearing side (20") spaced apart therefrom and parallel thereto has the receiving slots (21).

15. Enclosure according to claim 14, **characterised in that** the connecting area (27) disposed between the bearing sides (20', 20") is provided as a sidestop for a backplane printed circuit board (17).

16. Enclosure according to claim 15, **characterised in that** the bearing side (20') assigned to an inner wall of the enclosure has at least one fixing element (30) bent up from the bearing side (20') and acting as a spring, the free end (30') of which fixing element (30) faces towards the connecting area (27) and forms a counterstop for a backplane printed circuit board (17).

17. Enclosure according to claim 15 or 16,
**characterised in that** the bearing side (20') assigned to an inner wall of the enclosure has at least one contact element (31) bent up from the bearing side (20') and acting as a spring, the free end (31') of which contact element (31) faces the connecting area (27).

18. Enclosure according to claim 16 or 17,
**characterised in that** the fixing element (30) and the contact element (31) are each embodied in a trapezoidal shape.

19. Enclosure according to one of the claims 15 to 18,
**characterised in that** at least one fixing element (32) is provided which extends away from the bearing side (20") in such a way that the fixing element (32) remains in the plane defined by the bearing side (20") and projects with its free end (32') beyond the connecting area (27) towards the bearing side (20").

20. Enclosure according to claim 19, **characterised in that** the fixing element (32) is assigned an opening (28) provided in a backplane printed circuit board (17) in such a way that that the free end (32') projects through the opening (28) when the backplane printed circuit board (17) is brought to bear against the connecting area (27) in the intended manner.

21. Enclosure according to claim 19 or 20,
**characterised in that** the fixing element (32) is embodied as a U-shaped fastening clip.

22. Enclosure according to one of the claims 15 to 21,
**characterised in that** the fixing element (30), the contact element (31) and the fixing element (32) are spaced apart from one another in the direction of longitudinal extension of the profile rail (20).

23. Enclosure according to claim 22, **characterised in that** the fixing elements (30, 32) and the contact element (32) run approximately transversely to the direction of longitudinal extension of the profile rail (20).

24. Enclosure according to claim 22 or 23,
**characterised in that** the fixing element (30), the contact element (31) and the fixing element (32) are spaced apart from one another evenly in each case in the direction of longitudinal extension of the profile rail (20).

25. Enclosure according to one of the claims 1 to 24,
**characterised in that** opposite enclosure walls (14, 15) of the enclosure (10) each have a plurality of openings which pervade at least a substantial part of the surface area of the respective enclosure wall (14, 1b) in the form of a grid.

26. Enclosure according to claim 25, **characterised in that** the openings are embodied as perforations whose diameter does not exceed an order of magnitude of 2 mm.

27. Enclosure according to one of the claims 1 to 25,
**characterised in that** holes are provided at the corner areas of the enclosure (10).

## Revendications

1. Boîtier de réception de modules électriques, comprenant un habillage de boîtier entourant le boîtier, des moyens étant prévus pour fixer les modules dans le boîtier et des moyens étant prévus pour recevoir au moins une plaquette à circuit imprimé de paroi arrière associée aux modules,
**caractérisé**
**en ce qu'**il est prévu des rails (20) profilés ayant des tronçons (21) de réception à distance les uns des autres, en ce qu'il est associé, respectivement, à un certain format de module au moins deux tronçons (13) de guidage, dont la distance mutuelle est adaptée à la dimension du format de module, par le fait que les tronçons (13) de guidage peuvent être fixés dans des rails (20) profilés associés à des tronçons (21) de réception s'adaptant en fonction de la dimension du format respectif de module, et en ce que les moyens de réception d'une plaquette (17) à circuit imprimé de paroi arrière comportent des éléments (30, 31, 32) de fixation disposés sur un rail (20) profilé.

2. Boîtier suivant la revendication 1, **caractérisé en ce que** les rails (20) profilés sont disposés au moins par paires sur le côté (11) frontal et sur le côté arrière du boîtier (10).

3. Boîtier suivant la revendication 2, **caractérisé en ce que** les tronçons (21) de réception sont constitués dans les rails (20) profilés sous la forme de fentes de réception.

4. Boîtier suivant la revendication 3, **caractérisé en ce que** les fentes (21) de réception sont à distance mutuelle dans la direction d'étendue longitudinale du rail (20) profilé.

5. Boîtier suivant la revendication 4, **caractérisé en ce que** les fentes (21) de réception s'étendent en partant d'un bord (22) latéral du rail (20) profilé à peu près transversalement à la direction d'étendue longitudinale.

6. Boîtier suivant la revendication 4 ou 5, **caractérisé en ce que** les fentes (21) de réception ont une largeur de fente à peu près constante et une profondeur de fente à peu près constante.

7. Boîtier suivant la revendication 6, **caractérisé en ce que** la largeur des fentes (21) de réception est adaptée à peu près à l'épaisseur des tronçons (13) de guidage.

8. Boîtier suivant la revendication 7, **caractérisé en ce que** les tronçons (13) de guidage sont constitués sous la forme de plaques de guidage rectangulaires.

9. Boîtier suivant l'une des revendications 1 à 8, **caractérisé en ce que** les rails (20) profilés sont disposés respectivement sur au moins une paroi intérieure du boîtier (20).

10. Boîtier suivant la revendication 9, **caractérisé en ce que** les rails (20) profilés sont constitués de manière cintrée sur au moins l'une des parois intérieures du boîtier (10).

11. Boîtier suivant la revendication 9 ou 10, **caractérisé en ce qu'**il est prévu au moins une partie (18) de paroi intermédiaire sur les faces d'appui de laquelle sont disposés des rails (20) profilés.

12. Boîtier suivant l'une des revendications 1 à 11, **caractérisé en ce que** les rails (20) profilés ont, respectivement, une section transversale en forme de z.

13. Boîtier suivant la revendication 12, **caractérisé en ce que** les rails (20) profilés ont deux faces (20', 20") d'appui disposées parallèlement et à mises à distance l'une de l'autre par une zone (27) de liaison qui s'éloigne, respectivement, de la zone (27) de liaison disposée perpendiculairement aux faces (20', 20") d'appui.

14. Boîtier suivant la revendication 13, **caractérisé en ce qu'**une face (20') d'appui est destinée à s'appuyer sur une paroi intérieure du boîtier et la face (20") d'appui qui en est à distance et qui lui est parallèle comporte la fente (21) de réception.

15. Boîtier suivant la revendication 14, **caractérisé en ce que** la zone (27) de liaison interposée entre les faces (20', 20") d'appui est prévue sous la forme d'une butée latérale pour une plaque (17) à circuit imprimé de paroi arrière.

16. Boîtier suivant la revendication 15, **caractérisé en ce que** la face (20') d'appui associée à une paroi intérieure du boîtier a au moins un élément (30) de fixation recourbé élastiquement vers le haut à partir de la face (20') d'appui, dont l'extrémité (30') libre est tournée vers la zone (27) de liaison et forme une contre-butée pour une plaque (17) à circuit imprimé de paroi arrière.

17. Boîtier suivant la revendication 15 ou 16,
**caractérisé en ce qu'**une face (20') d'appui associée à une paroi intérieure du boîtier a au moins un élément (31) de contact recourbé vers le haut de manière élastique à partir de la face (20') d'appui et dont l'extrémité (31') libre est tournée vers la zone (27) de liaison.

18. Boîtier suivant la revendication 16 ou 17, **caractérisé en ce que** l'élément (30) de fixation et l'élément (31) de contact sont, respectivement, en forme de trapèze.

19. Boîtier suivant l'une des revendications 15 à 18, **caractérisé en ce qu'**il est prévu au moins un élément (32) de fixation qui s'étend à partir de la face (20") d'appui, de sorte que l'élément (32) de fixation reste dans le plan défini par la face (20") d'appui et fait saillie par son extrémité (32') libre au-delà de la zone (27) de liaison vers la face (20') d'appui.

20. Boîtier suivant la revendication 19, **caractérisé en ce qu'**il est associé à l'élément (32) de fixation une traversée (28) prévue dans une plaque (17) à circuit imprimé de paroi arrière, de sorte que lorsque la plaquette (17) à circuit imprimé de paroi arrière est en appui en coïncidence sur la zone (27) de liaison, l'extrémité (32') libre passe dans la traversée (28).

21. Boîtier suivant la revendication 19 ou 20, **caractérisé en ce que** l'élément (32) de fixation est constitué sous la forme d'une patte de fixation en forme de U.

22. Boîtier suivant l'une des revendications 15 à 21, **caractérisé en ce que** l'élément (30) de fixation, l'élément (31) de contact et l'élément (32) de fixation sont à distance les uns des autres suivant l'étendue longitudinale du rail (20) profilé.

23. Boîtier suivant la revendication 22, **caractérisé en ce que** les éléments (30, 32) de fixation et l'élément (31) de contact s'étendent à peu près transversalement à l'étendue longitudinale du rail (20) profilé.

24. Boîtier suivant la revendication 22 ou 23, **caractérisé en ce que** l'élément (30) de fixation, l'élément (31) de contact et l'élément (32) de fixation sont équidistants suivant l'étendue longitudinale du rail (20) profilé.

25. Boîtier suivant l'une des revendications 1 à 24, **caractérisé en ce que** des parois (14, 15) opposées du boîtier (10) ont, respectivement, une pluralité de traversées qui traversent en forme de grille au moins une partie sensible de la surface de la paroi (14, 15) de boîtier respective.

26. Boîtier suivant la revendication 25, **caractérisé en ce que** les traversées sont constituées en perforations dont le diamètre est d'un ordre de grandeur ne dépassant pas 2 mm.

27. Boîtier suivant l'une des revendications 1 à 25, **caractérisé en ce qu'**il est prévu des trous aux coins du boîtier (10).
